(19) Europäisches Patentamt
European Patent Office
Office européen des brevets

(11) **EP 4 307 861 A1**

(12) **EUROPEAN PATENT APPLICATION**
published in accordance with Art. 153(4) EPC

(43) Date of publication:
**17.01.2024 Bulletin 2024/03**

(21) Application number: **23782128.5**

(22) Date of filing: **03.01.2023**

(51) International Patent Classification (IPC):
**H10K 59/10** (2023.01)          **H01L 27/15** (2006.01)

(86) International application number:
**PCT/CN2023/070097**

(87) International publication number:
**WO 2023/216639 (16.11.2023 Gazette 2023/46)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **12.05.2022 CN 202210518090**

(71) Applicant: **Yungu (Gu'an) Technology Co., Ltd.
Langfang, Hebei 065500 (CN)**

(72) Inventors:
• **GAI, Cuili
  Langfang, Hebei 065500 (CN)**
• **GUO, Enqing
  Langfang, Hebei 065500 (CN)**
• **LI, Junfeng
  Langfang, Hebei 065500 (CN)**
• **XING, Rubo
  Langfang, Hebei 065500 (CN)**

(74) Representative: **Kraus & Weisert
Patentanwälte PartGmbB
Thomas-Wimmer-Ring 15
80539 München (DE)**

(54) **DISPLAY PANEL AND DISPLAY APPARATUS**

(57)    Provided are a display panel and a display device. The display panel has a display area and a bezel area. The bezel area includes a first bezel area and a second bezel area that are located on opposite sides of the display area. The display panel includes a cathode, a power supply connection portion, and at least one bonding connection portion. The cathode is disposed in the display area and the bezel area. The power supply connection portion includes a first connection portion and a second connection portion. The first connection portion is connected to the cathode in the first bezel area, the second connection portion is connected to the cathode in the second bezel area, and the first connection portion and the second connection portion supply power to the cathode. The bonding connection portion is located in the first bezel area, and connects the first connection portion and the second connection portion. Display unevenness caused by a cathode IR Drop is improved, thereby improving display uniformity.

FIG. 3

EP 4 307 861 A1

## Description

This application claims priority to Chinese Patent Application No. 202210518090.8, filed with the China National Intellectual Property Administration (CNIPA) on May 12, 2022, the disclosure of which is incorporated herein by reference in its entirety.

TECHNICAL FIELD

Embodiments of the present application relate to the field of display technology and, in particular, to a display panel and a display device.

BACKGROUND

With the continuous development of display technology, people put forward higher requirements for the performance of display panels.
A light-emitting device in a display panel needs to be connected to a power supply signal for driving the light-emitting device. Since a resistance exists on a transmission line of a power supply signal in a display panel in the related art, the transmission line of the power supply signal through which the driving current of a light-emitting device pass generates a current intensity resistance drop (IR Drop). In addition, the transmission line of the power supply signal generates different IR Drops in different areas of a display area, which results in poor uniformity of the driving currents of the light-emitting device in different areas, thereby causing display unevenness.

SUMMARY

Embodiments of the present application provide a display panel and a display device to improve display unevenness caused by a cathode IR Drop.
According to a first aspect, an embodiment of the present application provides a display panel having a display area and a bezel area. The bezel area includes a first bezel area and a second bezel area that are located on opposite sides of the display area. The display panel includes a cathode, a power supply connection portion, and at least one bonding connection portion.
The cathode is disposed in the display area and the bezel area.
The power supply connection portion includes a first connection portion and a second connection portion. The first connection portion is connected to the cathode in the first bezel area, the second connection portion is connected to the cathode in the second bezel area, and the first connection portion and the second connection portion are configured to supply power to the cathode.
The at least one bonding connection portion is located in the first bezel area and is connected to the first connection portion and the second connection portion.

According to a second aspect, an embodiment of the present application further provides a display device including the display panel according to the first aspect.
The display device further includes a flexible connection piece bonded to the bonding connection portion. At least one flexible connection piece is provided, and each of the at least one flexible connection piece is bonded to a corresponding bonded connection portion.
A display panel and a display device according to an embodiment of the present application improve display unevenness caused by a cathode IR Drop from the following two aspects. On the one hand, in a light-emitting phase, a part of the driving current on a cathode flow to a first connection portion, and the other part of the driving current flow to a second connection portion, so that a total amount of the driving current flowing to the first connection portion and a total amount of the driving currents flowing to the second connection portion are equal or approximately equal, which is equivalent to dividing an overall driving current of the cathode into two parts, thereby halving the driving current flowing on the cathode. This reduces an IR Drop generated by a power supply voltage in each area of the cathode, reduces a difference in the driving current of a light-emitting device in each area, and improves display uniformity. On the other hand, the bonding connection portion supplies the power supply voltage to the cathode in the first bezel area through the first connection portion, and supplies the power supply voltage to the cathode in the second bezel area through the second connection portion. In this manner, a difference in the driving ability of the bonding connection portion to the cathode in the first bezel area and the second bezel area is reduced, and a difference in the power supply voltage of the cathode in the first bezel area and the second bezel area is reduced, so as to enable the IR Drops of the power supply voltage on the cathode of the display area to be symmetrically distributed. In this manner, a difference between the driving current of the light-emitting device in the display area near the second bezel area and the driving current of the light-emitting device in the display area near the first bezel area is also reduced, and a difference between the display brightness of the display area near the second bezel area and the display brightness of the display area near the first bezel area is reduced, so that display uniformity of the display panel as a whole is improved.

BRIEF DESCRIPTION OF DRAWINGS

FIG. 1 is a schematic structural diagram of a display panel according to the related art.

FIG. 2 is a schematic structural diagram of a pixel circuit applied to a display panel.

FIG. 3 is a schematic structural diagram of a display panel according to an embodiment of the present application.

FIG. 4 is a diagram illustrating directions of a driving current in a display panel according to an embodiment of the present application.

FIG. 5 is a schematic structural diagram of another display panel according to an embodiment of the present application.

FIG. 6 is a schematic sectional view of the display panel of FIG. 5 taken along section line CC'.

FIG. 7 is a schematic sectional view of the display panel of FIG. 5 taken along section DD'.

FIG. 8 is a schematic structural diagram of another display panel according to an embodiment of the present application.

FIG. 9 is a schematic structural diagram of a display device according to an embodiment of the present application.

DETAILED DESCRIPTION

In order that the present application may be better understood by those skilled in the art, technical solutions of embodiments of the present application will be clearly and completely described in conjunction with the accompanying drawings. It will be apparent that the described embodiments are merely a part of the embodiments of the present application, rather than all the embodiments. Based on embodiments in the present application, all other embodiments obtained by those of ordinary skill in the art without creative work are within the protection scope of the present application.

As described in the background art, since a resistance exists on a transmission line of a power supply signal in a display panel in the related art, the transmission line of the power supply signal through which the driving current of a light-emitting device pass generates an IR Drop. In addition, the transmission line of the power supply signal generates different IR Drops in different areas of a display area, which results in poor uniformity of the driving currents of the light-emitting device in different areas, thereby causing display unevenness. It was found that the reasons for the above problems were as follows.

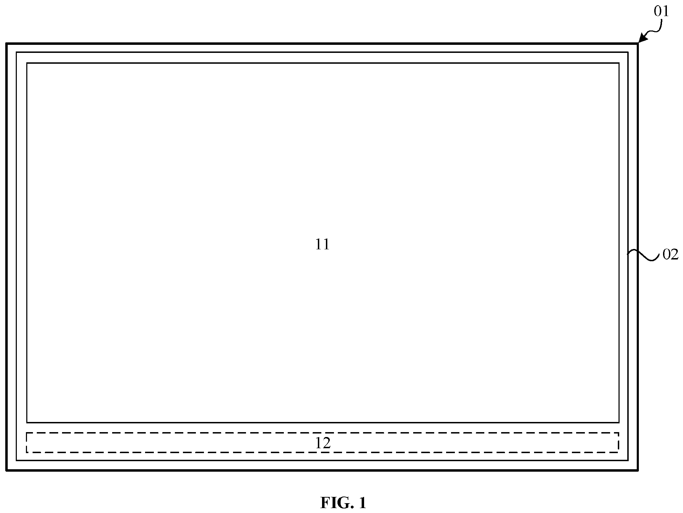

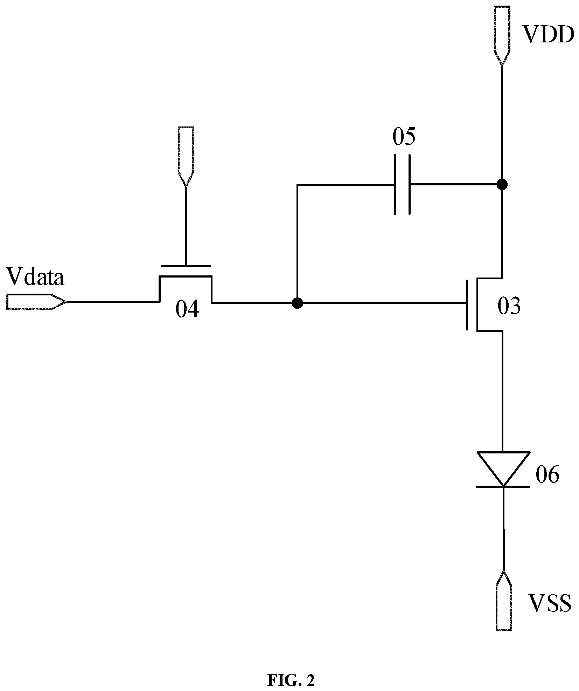

FIG. 1 is a schematic structural diagram of a display panel in the related art. FIG. 2 is a schematic structural diagram of a pixel circuit applied to a display panel. With reference to FIGS. 1 and 2, the display panel 01 has a display area 11 and a non-display area, the non-display area includes a lower bezel area 12, and the display area 11 includes a plurality of pixel circuits as shown in FIG. 2. A pixel circuit of the plurality of pixel circuits includes a driving transistor 03, a first transistor 04, and a storage capacitor 05. A first pole of the first transistor 04 is connected to a voltage data (Vdata). A first pole of the driving transistor 03 is connected to a first power supply voltage VDD. A second pole of the driving transistor 03 is connected to an anode of a light-emitting device 06. A cathode of the light-emitting device 06 is connected to a second power supply voltage VSS. The display panel 01 further includes a first electrode 02, which may be the cathode of the light-emitting device 06. Illustratively, a driving current I supplied by the pixel circuit to the light-emitting device 06 in a light-emitting phase may be expressed as follows.

$$I = K\,(Vdata - VSS - Voled - Vth)^2.$$

K=1/2 * $\mu$ * Cox * W/L, $\mu$ is mobility of the driving transistor 03, Cox is a gate insulating layer capacitance of the driving transistor 03, W/L is a channel width-length ratio of the driving transistor 03, Voled is a tube IR Drop of the light-emitting device 06, and Vth is a threshold voltage of the driving transistor 03. The first electrode 02 is generally connected to the second power supply voltage VSS in the lower bezel area 12 so that the second supply voltage VSS is transmitted from the first electrode 02 in the lower bezel area 12 to the first electrode 02 in the display area 11. Since the second power supply voltage VSS affects the magnitude of the driving current I, and a square resistance of the first electrode 02 is large, an IR Drop of the second power supply voltage VSS on the first electrode 02 is large as a whole. In addition, the second power supply voltage VSS on the first electrode 02 gradually increases in a direction from the lower bezel area 12 to the display area 11, which causes a large difference between the driving current I of the light-emitting device 06 in the display area 11 near the lower bezel area 12 and the driving current I of the light-emitting device 06 in the display area 11 far away from the lower bezel area 12, thereby causing a large difference between the display brightness of the display area 11 near the lower bezel area 12 and the display brightness of the display area 11 far away from the lower bezel area 12, resulting in display unevenness in the display panel.

An embodiment of the present application provides a display panel. The display panel may be an organic light-emitting diode (OLED) display panel, an active-matrix organic light-emitting diode (AMOLED) display panel, a micro light-emitting diode (Micro-LED) display panel, a liquid crystal display (LCD) panel, or the like.

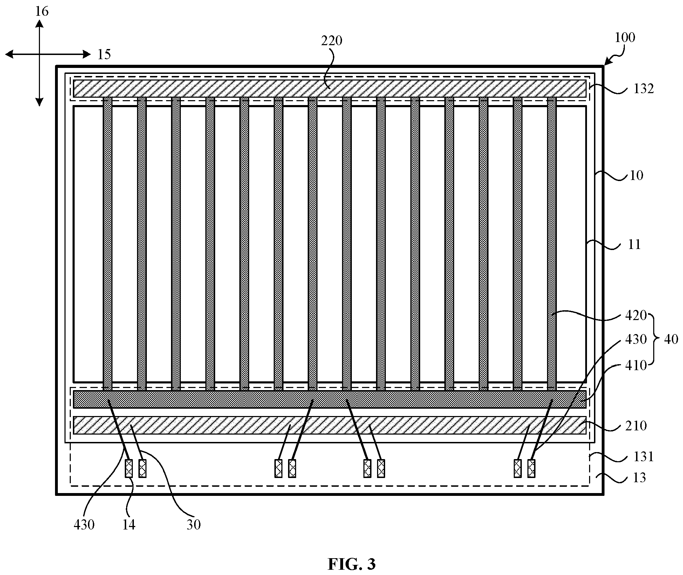

FIG. 3 is a schematic structure diagram of a display panel according to an embodiment of the present application. With reference to FIG. 3, the display panel has a display area 11 and a bezel area 13 surrounding the display area 11, and the bezel area 13 includes a first bezel area 131 and a second bezel area 132 that are located on opposite sides of the display area 11. In the embodiment of the present application, the first bezel area 131 is a lower bezel area, and the second bezel area 132 is an upper bezel area. In other embodiments, the first bezel area 131 may be an upper bezel area and the second bezel area 132 may be a lower bezel area. The display panel includes a cathode 10, a power supply connection portion, and a bonding connection portion 14. The cathode 10 is disposed in the display area 11 and the bezel area. The power supply connection portion includes a first connection portion 210 and a second connection portion 220. The first connection portion 210 is connected to the cathode 10 in a lower bezel area 131, and the second connection portion 220 is connected to the cathode 10 in an upper bezel area 132. The first connection portion 210 and the second connection portion 220 respectively supply power to the cathode 10. The bonding connection portion 14 is located in the lower bezel area 131 and is connected to the first connection portion 210 and the second connection portion 220.

Illustratively, the cathode 10 may be a planar electrode, and the cathode 10 is a common electrode of a light-emitting device in a display panel. The first connection portion 210 and the second connection portion 220 are both electrically connected to the cathode 10. For example, the cathode overlaps the second connection portion 220 at an edge portion of the upper bezel area 132, the cathode overlaps the first connection portion 210 at an edge portion of the lower bezel area 131, and the first connection portion 210 and the second connection portion 220 are overlapped with a side of the cathode 10 close to a non-display side of the display panel. The bonding connection 14 is used for being connected to a power supply voltage, and at least one bonding connection 14 is provided. When the lower bezel area 131 is provided with only one bonding connection portion 14, the bonding connection portion 14 is connected to the first connection portion 210 and the second connection portion 220 so as to supply power to the cathode 10 in the lower bezel area 131 through the first connection portion 210 and to supply power to the cathode 10 in the upper bezel area 132 through the second connection portion 220. A plurality of bonding connection portions 14 may also be provided. For example, as shown in FIG. 2, eight bonding connection portions 14 are provided in the lower bezel area 131. Four bonding connection portions of the eight bonding connection portions 14 are connected to the first connection portion 210 so as to supply power to the cathode 10 in the lower bezel area 131 through the four bonding connection portions 14 and the first connection portion 210, and the remaining four bonding connection portions 14 of the eight bonding connection portions 14 are connected to the second connection portion 220 so as to supply power to the cathode 10 in the upper bezel area 132 through the remaining four bonding connection portions 14 and the second connection portion 220.

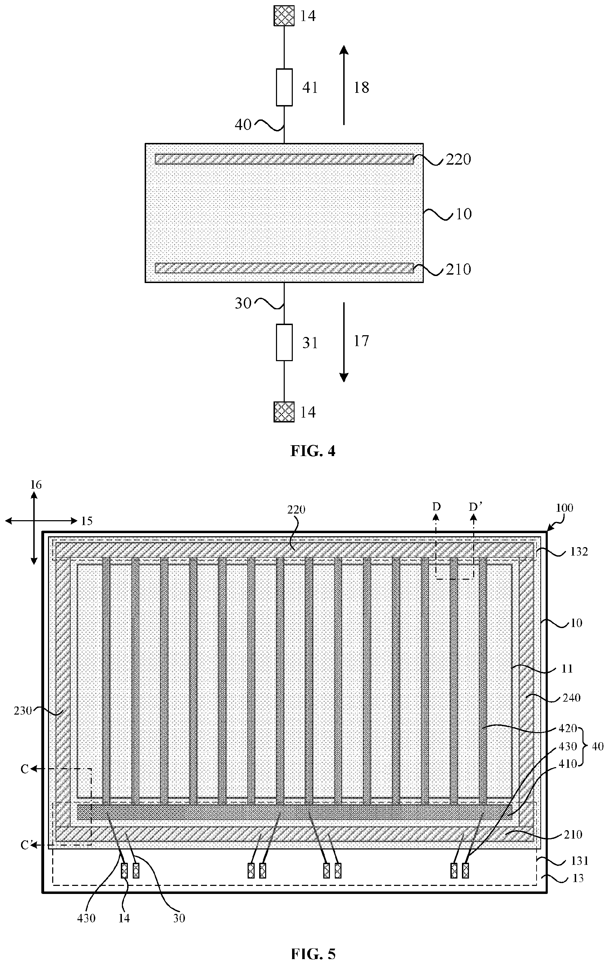

FIG. 4 is a diagram illustrating directions of a driving current in a display panel according to an embodiment of the present application. Illustratively, with reference to FIGS. 2 to 4, an example in which the display panel is provided with the pixel circuit shown in FIG. 2 will be described. The cathode 10 may be the cathode of the light-emitting device 06, and the bonding connection 14 may be connected to the second power supply voltage VSS, the second power supply voltage VSS is generally a low voltage, such as a 0 V voltage or a negative voltage. In a light-emitting phase, the driving current flows from an anode of each of the light-emitting devices 06 in the display area 11 to the cathode 10, and also flows through the cathode 10 of the light-emitting device 06 and the first connection portion 210 in the lower bezel area 131 to the corresponding bonding connection portion 14 in a third direction 17, and flows through the cathode 10 of the light-emitting device 06 and the second connection portion 220 in the upper bezel area 132 to the corresponding bonding connection portion 14 in a fourth direction 18. In this way, a part of the driving current on the cathode 10 flows to the first connection portion 210, and another part of the driving current on the cathode 10 flows to the second connection portion 220, so that the total amount of the driving current flowing to the first connection portion 210 and the total amount of the driving current flowing to the second connection portion 220 are equal or approximately equal. This is equivalent to dividing an overall driving current on the cathode 10 into two parts that flow to the first connection portion 210 and the second connection portion 220, respectively, thereby halving the driving current flowing on the cathode 10. Since an IR Drop generated by the second power supply voltage VSS on the cathode 10 is related to both the current and the resistance on the cathode 10, when the driving current on the cathode 10 is halved, the IR Drop generated by the second power supply voltage VSS on each area of the cathode 10 is reduced. The second power supply voltage VSS influences the magnitude of the driving current, which helps to reduce a difference in the driving current of the light-emitting device 06 in each area, thereby improving display uniformity. Moreover, when the current flowing on the cathode 10 is reduced, power consumption is reduced. The technical solutions of the embodiments of the present application can greatly reduce power consumption.

In addition, the bonding connection portion 14 supplies the second power supply voltage VSS to the cathode 10 in the lower bezel area 131 through the first connection portion 210, and supplies the second power supply voltage VSS to the cathode 10 in the upper bezel area 132 through the second connection portion 220, so that the second power supply voltage VSS is supplied to the cathode 10 in the display area 11 from the cathode 10 in the lower bezel area 131 and the cathode 10 in the upper bezel area 132. This contributes to reducing a difference in the driving ability of the bonding connection portion 14 to the cathode 10 in the lower bezel area 131 and to the cathode 10 in the upper bezel area 132, and reduces a difference in the second power supply voltage VSS on the cathode 10 in the lower bezel area 131 and on the cathode 10 in the upper bezel area 132, so as to enable the IR Drops of the second power supply voltage VSS on the cathode 10 in the display area 11 to be symmetrically distributed. In this manner, a difference between the driving current of the light-emitting device 06 in the display area 11 near the upper bezel area 132 and the driving current of the light-emitting device 06 in the display area 11 near the lower bezel area 131 is also reduced, and a difference between the display brightness of the display area 11 near the upper bezel area 132 and the display brightness of the display area 11 near the lower bezel area 131 is reduced, so that display uniformity of the display panel as a whole is improved.

In summary, the technical solutions of the embodiments of the present application are useful for improving display unevenness caused by a cathode IR Drop from the following two aspects. On the one hand, in a light-emitting phase, a part of driving current on a cathode flows to a first connection portion, and the other part of the driving current flows to a second connection portion, so that a total amount of the driving current flowing to the first connection portion and a total amount of the driving current flowing to the second connection portion are equal or approximately equal, which is equivalent to dividing an overall driving current of the cathode into two parts, thereby halving the driving current flowing on the cathode. This reduces an IR Drop generated by a power supply voltage in each area of the cathode, reduces a difference in the driving current of a light-emitting device in each area, and improves display uniformity. On the other hand, the bonding connection portion supplies the power supply voltage to the cathode in the first bezel area through the first connection portion, and supplies the power supply voltage to the cathode in the second bezel area through the second connection portion. This contributes to reducing a difference in the driving ability of the bonding connection portion to the cathode in the first bezel area and the second bezel area, and to reducing a difference in the power supply voltage of the cathode in the first bezel area and the second bezel area, so as to enable the IR Drops of the power supply voltage on the cathode in the display area to be symmetrically distributed. In this manner, a difference between the driving current of the light-emitting device in the display area near the second bezel area and the driving current of the light-emitting device in the display area near the first bezel area is reduced, and a difference between the display brightness in the display area near the second bezel area and the display brightness in the display area near the first bezel area is reduced, so that display uniformity of the display panel as a whole is improved.

FIG. 5 is a schematic structural diagram of another display panel according to an embodiment of the present application. With reference to FIG. 5, on the basis of the preceding embodiment, optionally, the first connection portion 210 and the second connection portion 220 are strip-shaped. The first connection portion 210 extends along an edge of the cathode 10 in the lower bezel area 131, and the second connection portion 220 extends along an edge of the cathode 10 in the upper bezel area 132. The first connection portion 210 can supply power to the edge of the cathode 10 located in the lower bezel area 131, the second connection portion 220 can supply power to the edge of the cathode 10 located in the upper bezel area 132, and the first connection portion 210 and the second connection portion 220 can be symmetrically distributed on both upper and lower edges of the cathode 10. In this manner, it has the following advantages. On the one hand, in a light-emitting phase, the total amount of driving current flowing to the first connection portion 210 and the total amount of driving current flowing to the second connection portion 220 are brought closer, thereby halving the driving current flowing on the cathode 10. In this manner, an IR Drop generated by a power supply voltage in each area of the cathode is reduced, a difference in the driving current of a light-emitting device in each area is reduced, and display uniformity is improved. On the other hand, the first connection portion 210 and the second connection portion 220 extend along the edge of the cathode 10 in the lower bezel area 131 and the edge of the cathode 10 in the upper bezel area 132. This contributes to reducing a difference in the driving ability of the bonding connection portion 14 to the upper and lower edges of the cathode 10, and to reducing a difference in the second power supply voltage VSS of the upper and lower edges of the cathode 10, so as to enable the IR Drops of the second power supply voltage VSS on the cathode 10 in the display area 11 to be symmetrically distributed. In this manner, a difference between the driving current of the light-emitting device 06 in the display area 11 near the upper bezel area 132 and the driving current of the light-emitting device 06 in the display area 11 near the lower bezel area 131 is also reduced, and a difference between the display brightness of the display area 11 near the upper bezel area 132 and the display brightness of the display area 11 near the lower bezel area 131 is reduced, so that display uniformity of the display panel as a whole is improved.

With continued reference to FIG. 5, optionally, the power supply connection portion further includes a left connection portion 230 and a right connection portion 240 in the bezel area. The left connection portion 230 is connected between a first end of the first connection portion 210 and a first end of the second connection portion 220, and the right connection portion 240 is connected between a second end of the first connection portion 210 and a second end of the second connection portion 220.

Illustratively, the left connection portion 230 and the right connection portion 240 are strip-shaped. The left connection portion 230 may be connected to the cathode 10 in the left bezel area and extends along an edge of the cathode 10 in the left bezel area. The right connection portion 240 may be connected to the cathode 10 in the right bezel area and extends along an edge of the cathode 10 in the right bezel area. The first connection portion 210, the second connection portion 220, the left connection portion 230, and the right connection portion 240 are overlapped with a side of the cathode 10 adjacent to a non-display side of the display panel. For example, when the display panel includes a plurality of pixel circuits as shown in FIG. 2, the cathode 10 may be a cathode of the light-emitting device 06, and the bonding connection 14 may be connected to the second power supply voltage VSS. By providing the left connection portion 230 and the right connection portion 240, the driving current on the cathode 10 flows to the first connection portion 210, the second connection portion 220, the left connection portion 230 and the right connection portion 240, so that the total amount of the driving current flowing to the first connection portion 210, the total amount of the driving current flowing to the second connection portion 220, the total amount of the driving current flowing to the left connection portion 230 and the total amount of the driving current flowing to the right connection portion 240 are approximately equal, which is equivalent to dividing an overall driving current of the cathode 10 into a plurality of parts. In this way, the driving current of each light-emitting device 06 can be reduced, and the IR Drop generated by the second power supply voltage VSS in each area of the cathode 10 can be reduced, thereby reducing a difference in the driving current of the light-emitting device 06 in each area, thereby improving display uniformity.

With continued reference to FIG. 5, optionally, the display panel further includes a first conductive line 30 and a second conductive line 40. The first conductive line 30 is connected between the first connection portion 210 and the corresponding bonding connection portion 14, and the second conductive line 40 is connected between the second connection portion 220 and the corresponding bonding connection portion 14. Illustratively, a plurality of the first conductive lines 30 and a plurality of the second conductive lines 40 may be provided, each of the first conductive lines 30 is connected to a corresponding bonding connection portion 14, and each of the second conductive lines 40 is connected to a corresponding bonding connection portion 14, respectively. The bonding connection portion 14 may supply a power source to the cathode in the lower bezel area 131 through the first conductive line 30 and the first connection portion 210, and may supply a power source to the cathode in the upper bezel area 132 through the second conductive line 40 and the second connection portion 220.

With reference to FIGS. 4 and 5, on the basis of the preceding embodiment, optionally, a ratio of a resistance 31 of the first conductive line 30 to a resistance 41 of the second conductive line 40 is positively correlated with a ratio of a voltage value of a signal to which the first conductive line 30 is connected and a voltage value of a signal to which the second conductive line 40 is connected. For ease of explanation, a power supply voltage connected to the bonding connection portion 14 connected to the first conductive line 30 is denoted as V1, a power supply voltage connected to the bonding connection portion 14 connected to the second conductive line 40 is denoted as V2, the resistance value of the resistance 31 of the first conductive line 30 is denoted as R1, and the resistance value of the resistance 41 of the second conductive line 40 is denoted as R2. Illustratively, the ratio of the resistance 31 of the first conductive line 30 to the resistance 41 of the second conductive line 40 is positively correlated with the ratio of the voltage value of the signal to which the first conductive line 30 is connected and the voltage value of the signal to which the second conductive line 40 is connected, which may be expressed as $(R1/R2) \propto (V1/V2)$. When the resistance 31 of the first conductive line 30 is larger with respect to the resistance 41 of the second conductive line 40, in order to equalize the driving abilities of the bonding connection portion 14 with respect to the cathode 10 in the lower bezel area 131 and the cathode 10 in the upper bezel area 132, and to reduce a difference in the power supply voltage between the cathode 10 in the lower bezel area 131 and the cathode 10 in the upper bezel area 132, the larger the power supply voltage V1 to which the first conductive line 30 is connected to is set with respect to the power supply voltage V2 to which the second conductive line 40 is connected. When the resistance 31 of the first conductive line 30 is smaller with respect to the resistance 41 of the second conductive line 40, in order to equalize the driving abilities of the bonding connection portion 14 with respect to the cathode 10 in the lower bezel area 131 and the cathode 10 in the upper bezel area 132, and to reduce a difference in the power supply voltage between the cathode 10 in the lower bezel area 131 and the cathode 10 in the upper bezel area 132, the smaller the power supply voltage V1 to which the first conductive line 30 is connected is set with respect to the power supply voltage V2 to which the second conductive line 40 is connected.

In an embodiment, the resistance 31 of the first conductive line 30 may be set equal to the resistance 41 of the second conductive line 40. When the bonding connection portion 14 connected to the first conductive line 30 and the second conductive line 40 is connected to the same power supply voltage, the driving abilities of the bonding connection portion 14 for the cathode in the lower bezel area 131 and the cathode 10 in the upper bezel area 132 are the same, and the second power supply voltage VSS on the cathode in the lower bezel area 131 and the second power supply voltage VSS on the cathode 10 in the upper bezel area 132 are the same, so as to enable the IR Drops of the second power supply voltage VSS on the cathode 10 in the display area 11 to be symmetrically distributed. In this manner, a difference between the driving current of the light-emitting device 06 in the display area 11 near the upper bezel area 132 and the driving current of the light-emitting device 06 in the display area 11 near the lower bezel area 131 is reduced, and a difference between the display brightness of the display area 11 near the upper bezel area 132 and the display brightness of the display area 11 near the lower bezel area 131 is reduced, so that display uniformity of the display panel as a whole is improved.

With reference to FIG. 5, since the first connection portion 210 and the bonding connection portion 14 are both located in the lower bezel area, the first conductive line 30 can directly connect the first connection portion 210 and the corresponding bonding connection portion 14 in the lower bezel area 131. The second conductive line 40 may be provided in a plurality of ways. In an embodiment, the second conductive line 40 may include a backbone conductive line 410 and a plurality of branch conductive lines 420. The backbone conductive line 410 is connected to the bonding connection portion 14, and a branch conductive line of the plurality of branch conductive lines 420 is connected between the backbone conductive line 410 and the second connection portion 220. The backbone conductive line 410 extends in a first direction 15, the branch conductive line 420 extends in a second direction 16 and passes through the display area 11, and the first direction 15 intersects the second direction 16.

Illustratively, the backbone conductive line 410 and the branch conductive lines 420 are strip-shaped, the backbone conductive line 410 is provided in the lower bezel area 131, and the branch conductive line 420 extends from the lower bezel area 131 to the display area 11 in the second direction 16. The bonding connection portion 14 may supply power to the cathode 10 in the upper bezel area 132 through the backbone conductive line 410, the branch conductive line 420, and the second connection portion 220. Optionally, the plurality of branch conductive lines 420 are uniformly distributed in the display area 11, so that power supply voltages supplied from the bonding connection portion 14 to a plurality of positions of the second connection portion 220 through the backbone conductive lines 410 and the plurality of branch conductive lines 420 are uniform, thereby reducing the IR Drop of the power supply voltage on the cathode 10. The uniform distribution of the plurality of branch conductive lines 420 can present a uniform display, thereby reducing the influence on the display effect.

With continued reference to FIG. 5, the display area 11 includes a plurality of columns of sub-pixels. In an embodiment, one branch conductive line 420 may be provided for each n column of sub-pixels, and n is an integer greater than or equal to 1. Illustratively, when n = 1, each column of sub-pixels corresponds to one branch conductive line 420, so that power supply voltages supplied from the bonding connection portion 14 to the second connection portion 220 through the backbone conductor 410 and the plurality of branch conductive lines 420 corresponds to each column of sub-pixel position are uniform, thereby reducing the IR Drop of the power supply voltage at the cathode 10 corresponding to each column of sub-pixel position. In the case of n > 1, one branch conductive line 420 may be provided for columns of sub-pixels. In this way, not only the power supply voltages supplied from the bonding connection portion 14 to the plurality of positions of the second connection portion 220 through the backbone conductive line 410 and the plurality of branch conductive lines 420 are uniform, thereby reducing the IR Drop of the power supply voltage on the cathode 10, but also the number of the branch conductive lines 420 can be reduced, thereby simplifying the process of the display panel. In other embodiments, the number of the branch conductive lines 420 may also be set according to an IR Drop simulation result of the cathode 10, so that the number of the set branch conductive lines 420 can reduce the IR Drop of the cathode 10.

With continued reference to FIG. 5, optionally, the second conductive line 40 further includes a conductive connection line 430, and the backbone conductive line 410 is connected to the bonding connection 14 through the conductive connection line 430. A ratio of a sum of a resistance of the conductive connection line 430 and a resistance of the branch conductive line 420 to the resistance of the first conductive line 30 is positively correlated with a ratio of a voltage value of a signal to which the conductive connection line 430 is connected to the voltage value of the signal in which the first conductive line 30 is connected. Illustratively, the conductive connection line 430 may be provided in the lower bezel area 131, and the bonding connection portion 14 may supply power to the cathode 10 in the upper bezel area 132 through the conductive connection line 430, the backbone conductive line 410, the branch conductive line 420, and the second connection portion 220 in sequence.

Illustratively, with reference to FIGS. 4 and 5, when the resistance of the conductive connection line 430 is denoted as R21, the resistance of the branch conductive line 420 is denoted as R22, the power supply voltage connected to the bonding connection portion 14 connected to the first conductive line 30 is denoted as V1, and the power supply voltage connected to the bonding connection portion 14 connected to the conductive connection line 430 is denoted as V2, R21 + R22 ≈ R2. By setting the ratio of the sum (R21+R22) of the resistance of the conductive connection line 430 and the resistance of the branch conductive line 420 to the resistance 31 of the first conductive line 30 positively correlated with the ration of the power supply voltage V2 to which the conductive connection line 430 is connected to the power supply voltage V1 to which the first conductive line 30 is connected, the driving abilities of the bonding connection portion 14 to the cathode 10 in the lower bezel area 131 and to the cathode 10 in the upper bezel area 132 are equalized, and a difference in the power supply voltage between the cathode 10 in the lower bezel area 131 and the cathode 10 of the upper bezel area 132 is reduced.

In an embodiment, the sum (R21 + R22) of the resistance of the conductive connection line 430 and the resistance of the branch conductive lines 420 is equal to the resistance 31 of the first conductive lines 30. Therefore, when the conductive connection line 430 and the first conductive lines 30 are connected to the same power supply voltage, the driving ability of the bonding connection portion 14 for the cathode 10 in the lower bezel area 131 and the driving ability of the bonding connection portion 14 for the cathode 10 in the upper bezel area 132 are the same, and the second power supply voltage VSS on the cathode 10 in the lower bezel area 131 and the second power supply voltage VSS on the cathode 10 in the upper bezel area 132 are the same, so as to enable the IR Drops of the second power supply voltage VSS on the cathode 10 in the display area 11 to be symmetrically distributed. In this manner, a difference between the driving current of the light-emitting device 06 in the display area 11 near the upper bezel area 132 and the driving current of the light-emitting device 06 in the display area 11 near the lower bezel area 131 is reduced, and a difference between the display brightness of the display area 11 near the upper bezel area 132 and the display brightness of the display area 11 near the lower bezel area 131 is reduced, so that display uniformity of the display panel as a whole is improved.

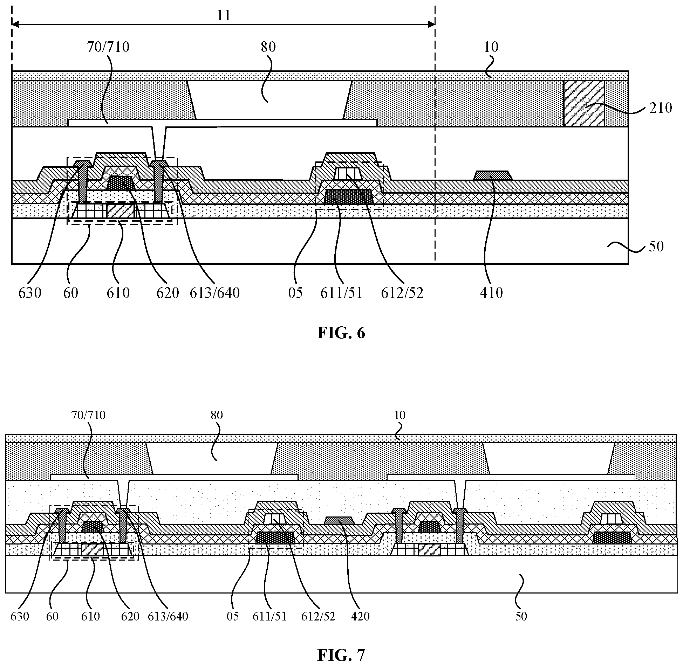

FIG. 6 is a schematic sectional view of the display panel of FIG. 5 taken along section line CC'. With reference to FIGS. 5 and 6, on the basis of the preceding embodiments, optionally, the display panel includes a substrate 50, and an anode layer 70 and a light-emitting layer 80 that are disposed on the substrate 50. The light-emitting layer 80 is disposed between the anode layer 70 and the cathode 10, and the power supply connection portion is disposed in the same layer as the anode layer 70.

In particular, the substrate 50 may play a role in cushioning, protecting, or supporting for the display panel. The anode layer 70 includes a plurality of anodes 710, and the anode 710, the light-emitting layer 80, and the cathode 10 constitute a plurality of light-emitting devices in the display panel. The power supply connection portion is provided in the same layer as the anode layer 70 and is located in the bezel area. FIG. 6 shows only the first connection portion 210 in the lower bezel area 131 and connected to a side of the cathode 10 adjacent to the substrate 50. Other power supply connection portions, such as the second connection portion 220, the left connection portion 230, and the right connection portion 240, may be provided in the same layer as the anode layer 70 and connected to the side of the cathode 10 adjacent to the substrate 50. By providing the power supply connection portion with the anode layer 70 in the same layer, it is not necessary to add an additional metal layer to the display panel to form the power supply connection portion, so as to avoid increasing the thickness of the display panel.

With reference to FIGS. 5 and 6, optionally, the display panel further includes a pixel circuit disposed on the substrate 50, the pixel circuit includes a plurality of metal layers, the first conductive line 30 and the second conductive line 40 are disposed in the same layer as the at least one metal layer of the plurality of metal layers.

Illustratively, the pixel circuit further includes an active layer 610, and the plurality of metal layers include a first metal layer 611, a second metal layer 612, and a third metal layer 613. The pixel circuit includes a thin film transistor 60 and a storage capacitor 05. The thin film transistor 60 may be a thin film transistor connected to an anode 710, such as a drive transistor 03 shown in FIG. 2. The storage capacitor 05 may be a storage capacitor 05 shown in FIG. 2. A gate 620 of the thin film transistor 60 and a first electrode plate 51 of the storage capacitor 05 are located in the first metal layer 611. A second electrode plate 52 of the storage capacitor 05 is located in the second metal layer 612. A first electrode 630 and a second electrode 640 of the thin film transistor 60 are located in the third metal layer 613, and one of the first electrode 630 and the second electrode 640 is a source electrode and the other one of the first electrode 630 and the second electrode 640 is a drain electrode. The first conductive line 30 and the second conductive line 40 may be disposed in any one of the first metal layer 611, the second metal layer 612, and the third metal layer 613, and are connected to corresponding power supply connection portions through via holes. FIG. 6 only shows a case where the backbone conductive line 410 in the second conductive line 40 is located in the third metal layer 613, and the branch conductive line 420 and the conductive connection line 430 in the second conductive line 40 and the first conductive line 30 may be provided in the same layer as the backbone conductive line 410. Since the third metal layer 613 is close to the anode layer 70, it is possible to facilitate the connection of the first conductive line 30 and the second conductive line 40 to the corresponding power supply connection portions.

FIG. 6 shows only three metal layers of the pixel circuit. In other embodiments, the display panel may also include a fourth metal layer located between the anode layer 70 and the third metal layer 613. For example, a power supply line for transmitting the first power supply voltage VDD is located in the fourth metal layer. The backbone conductive line 410, the branch conductive line 420, the conductive connection line 430 which are included in the second conductive line 40, and the first conductive line 30 may also be provided in the fourth metal layer, so that the first conductive line 30 and the second conductive line 40 are connected to the corresponding power supply connection portions.

FIG. 7 is a schematic sectional view of the display panel of FIG. 5 taken along section DD'. With reference to FIGS. 5 and 7, optionally, in an embodiment, a vertical projection of the second conductive line 40 on the substrate 50 does not overlap a vertical projection of the anode 710 on the substrate 50. Illustratively, the second conductive line 40 includes the backbone conductive line 410, the branch conductive line 420, and the conductive connection line 430. Vertical projections of the backbone conductive line 410, the branch conductive line 420, and the conductive connection line 430 on the substrate 50 are not overlapped with the vertical projection of the anode 710 on the substrate 50. For example, FIG. 7 shows that the vertical projection of the branch conductive line 420 on the substrate 50 does not overlap the vertical projection of the anode 710 on the substrate 50. Since the backbone conductive line 410 and the conductive connection line 430 are located in the lower bezel area 131, the vertical projection of the whole second conductive line 40 on the substrate 50 does not overlap the vertical projection of the anode 710 on the substrate 50.

Optionally, in other embodiments, at least a portion of a vertical projection of the second conductive line 40 on the substrate 50 overlaps a vertical projection of the anode 710 on the substrate 50. For example, a vertical projection of the branch conductive line 420 on the substrate 50 overlaps the vertical projection of the anode 710 on the substrate 50. This enables the branch conductive line 420 to be positioned below the anode 710 to shield the branch conductive line 420 through the anode 710, thereby preventing the branch conductive line 420 from affecting display effect.

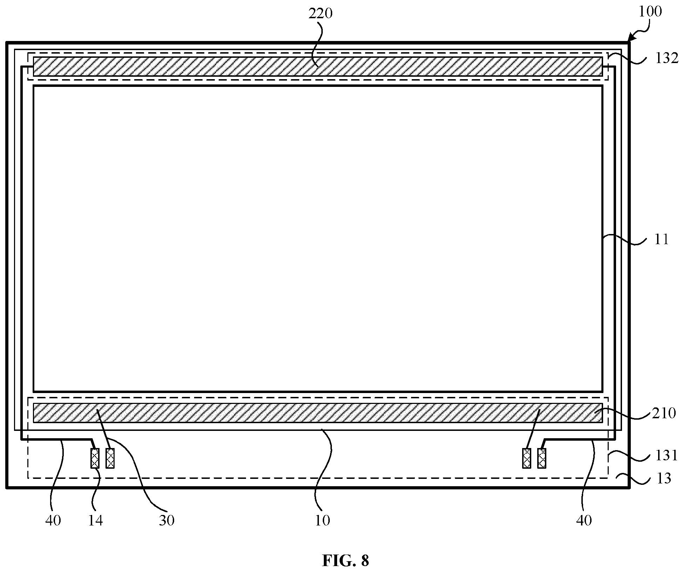

FIG. 8 is a schematic structural diagram of another display panel according to an embodiment of the present application. With reference to FIG. 8, optionally, in another embodiment, both the first conductive line 30 and the second conductive line 40 may be provided in the bezel area. Two second conductive lines 40 are provided, one of the two second conductive lines 40 is connected between a first end of the second connection portion 220 and the bonding connection portion 14, and the other one of the second conductive lines 40 is connected between a second end of the second connection portion 220 and the bonding connection portion 14. The two second conductive lines 40 may be connected to different bonding connection portions 14, respectively, or may be connected to the same bonding connection 14 to supply power to the cathode 10 located in the upper bezel area 132 through the bonding connection 14 and the second conductive line 40. In this embodiment, the first conductive line 30 and the second conductive line 40 may likewise be provided in the same layer as the at least one metal layer of the pixel circuit.

On the basis of the preceding embodiments, optionally, the first conductive line 30 and the second conductive line 40 may each include a titanium layer, an aluminum layer, and a titanium layer that are stacked.

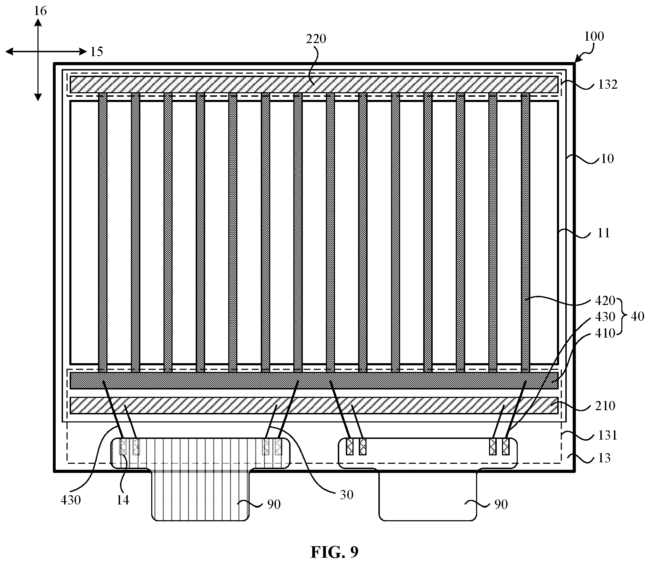

An embodiment of the present application further provides a display device, which may be a mobile phone, a computer, a tablet computer, or the like. FIG. 9 is a schematic structural diagram of the display device according to the embodiment of the present application. With reference to FIG. 9, the display device includes the display panel in any of the preceding embodiments, and further includes a flexible connection piece 90 bonded the bonding connection portion 14. At least one flexible connection piece 90 is provided, and each of the at least one flexible connection piece 90 is bonded to a corresponding bonding connection portion 14.

Illustratively, the flexible connection piece 90 may be a flexible printed circuit (FPC). The display device may be a display device using a chip on film (COF) encapsulation technology. For example, a driver chip in the display device may be provided on the flexible connection piece 90 and bonded to the lower bezel area 131 of the display panel through the flexible connection piece 90. The display device may also be a display device using a chip on glass (COG) encapsulation technology. For example, the driving chip is directly provided on a lower bezel area 131 of the display panel, and the flexible connection member 90 is bonded to a bonding connection portion in the lower bezel area 131.

Each flexible connection piece 90 includes a plurality of lines, and the number of lines in the flexible connection piece 90 corresponds to the number of bonding connection portions 14 in the display panel. A bonding connection 14 is connected to a corresponding line in the flexible connection piece 90 so that the display device supplies power to the bonding connection 14 through the flexible connection piece 90. The number of the bonding connection portions 14 may be set in accordance with the IR Drop of the cathode 10. FIG. 9 shows that the lower bezel area 131 includes eight bonding connection portions 14. When the display device includes two flexible connection pieces 90, one flexible connection piece 90 in the two flexible connection pieces 90 is set to be bonded to two bonding connection portions 14 connected to the first connection portion 210 and two bonding connection portions 14 connected to the second connection 220 so as to supply power to the corresponding bonding connection portions 14 through the lines in the flexible connection 90, and the other flexible connection piece 90 in the two flexible connection pieces 90 is set to be bonded to the other two bonding connection portions 14 connected to the first connection portion 210 and the other two bonding connection portions 14 connected to the second connection 220 so as to supply power to the corresponding bonding connection portions 14 through the lines in the flexible connection 90.

The preceding embodiments are described by way of example only in which the display device includes two flexible connection pieces 90. In other embodiments, one or more flexible connection pieces 90 may be provided. For example, when the display device includes one flexible connection piece 90, the flexible connection piece 90 may be bonded to all of the bonding connection portions 14 so as to supply power to each of the bonding connection portions 14 through lines in the flexible connection piece 90. When the display device includes a plurality of flexible connection pieces 90, each of the plurality of flexible connection pieces 90 may be bonded to a corresponding bonding connection portion 14 so as to supply power to the corresponding bonding connection portion 14 through lines in each of the plurality of flexible connection pieces 90.

The display device provided in the embodiment of the present application includes the display panel in any of the preceding embodiments, and thus has a corresponding structure and advantageous effect of the display panel. Details are not repeated herein.

With continued reference to FIG. 9, optionally, lines disposed on a flexible connection piece of the at least one flexible connection piece and connected to corresponding bonding connection portions are shorted. By shorting the lines connected the corresponding bonding connection portions 14 in the flexible connection piece 90, the same power supply voltage can be supplied to each bonding connection portion 14 through the flexible connection member 90. When the resistance of the first conductive line 30 is equal to the resistance of the second conductive line 40, the driving abilities of the display device for the cathode 10 in the lower bezel area 131 and the upper bezel area 132 are the same, and the power supply voltages on the cathode 10 in the lower bezel area 131 and the upper bezel area 132 are also the same, so as to enable the IR Drops of the power supply voltage on the cathode 10 in the display area 11 to be symmetrically distributed. In this manner, a difference between the driving current of the light-emitting device 06 in the display area 11 near the upper bezel area 132 and the driving current of the light-emitting device 06 in the display area 11 near the lower bezel area 131 is reduced, and a difference between the display brightness of the display area 11 near the upper bezel area 132 and the display brightness of the display area 11 near the lower bezel area 131 is reduced, so that display uniformity of the display panel as a whole is improved.

The protection scope of the present application is not limited to the preceding embodiments. It is to be understood by those skilled in the art that various modifications, combinations, subcombinations, and substitutions may be made according to design requirements and other factors. Any modifications, equivalent substitutions, improvements and the like made within the spirit and principle of the present application are within the protection scope of the present application.

**Claims**

1. A display panel having a display area and a bezel area, wherein the bezel area comprises a first bezel area and a second bezel area that are located on opposite sides of the display area, and the display panel comprises:

    a cathode disposed in the display area and the bezel area;
    a power supply connection portion comprising a first connection portion and a second connection portion, wherein the first connection portion is connected to the cathode in the first bezel area, the second connection portion is connected to the cathode in the second bezel area, and the first connection portion and the second connection portion are configured to supply power to the cathode; and
    at least one bonding connection portion located in the first bezel area and connecting the first connection portion and the second connection portion.

2. The display panel of claim 1, wherein the power supply connection portion further comprises a left connection portion and a right connection portion that are located in the bezel area, the left connection portion is connected between a first end of the first connection portion and a first end of the second connection portion, and the right connection portion is connected between a second end of the first connection portion and a second end of the second connection portion.

3. The display panel of claim 1, wherein the first connection portion and the second connection portion are strip-shaped, the first connection portion extends along an edge of the cathode located in the first bezel area, and the second connection portion extends along an edge of the cathode located in the second bezel area.

4. The display panel of claim 1, wherein the display panel further comprises a first conductive line and a second conductive line, wherein

    the first conductive line is connected between the first connection portion and a corresponding bonding connection portion; and
    the second conductive line is connected between the second connection portion and a corresponding bonding connection portion.

5. The display panel of claim 4, wherein a ratio of a resistance of the first conductive line to a resistance of the second conductive line is positively correlated with a ratio of a voltage value of a signal to which the first conductive line is connected and a voltage value of a signal to which the second conductive line is connected.

6. The display panel of claim 4, wherein a resistance of the first conductive line is equal to a resistance of the second conductive line.

7. The display panel of claim 4, wherein the first conductive line and the second conductive line are located in the bezel area, two second conductive lines are provided, one of the two second conductive lines is connected between a first end of the second connection portion and a corresponding bonding connection portion, and the other one of the two second conductive lines is connected between a second end of the second connection portion and a corresponding bonding connection portion.

8.  The display panel of claim 4, wherein the second conductive line comprises a backbone conductive line and a plurality of branch conductive lines, the backbone conductive line is connected to a corresponding bonding connection portion, and a branch conductive line of the plurality of branch conductive lines is connected between the backbone conductive line and the second connection portion; and the backbone conductive line extends in a first direction, and the branch conductive line extends in a second direction and passes through the display area, wherein the first direction intersects the second direction.

9.  The display panel of claim 8, wherein each n columns of sub-pixels of the display panel correspond to one branch conductive line of the plurality of branch conductive lines, wherein n is an integer greater than or equal to 1.

10. The display panel of claim 8, wherein the second conductive line further comprises a conductive connection line, wherein the backbone conductive line is connected to the corresponding bonding connection portion through the conductive connection line; and a ratio of a sum of a resistance of the conductive connection line and a resistance of the branch conductive line to the resistance of the first conductive line is positively correlated with a ratio of a voltage value of a signal to which the conductive connection line is connected to the voltage value of the signal to which the first conductive line is connected.

11. The display panel of claim 10, wherein the sum of the resistance of the conductive connection line and the resistance of the branch conductive line is equal to the resistance of the first conductive line.

12. The display panel of claim 4, wherein the display panel comprises a substrate and an anode layer on the substrate, and the anode layer comprises a plurality of anodes; and a vertical projection of the second conductive line on the substrate does not overlap a vertical projection of an anode of the plurality of anodes on the substrate.

13. The display panel of claim 4, wherein the display panel comprises a substrate and an anode layer on the substrate, and the anode layer comprises a plurality of anodes; and at least a portion of a vertical projection of the second conductive line on the substrate overlaps a vertical projection of an anode of the plurality of anodes on the substrate.

14. The display panel of claim 1, wherein the at least one bonding connection portion is configured to access a power supply voltage and connects the first connection portion and the second connection portion to supply power to the cathode in the first bezel area through the first connection portion and to supply power to the cathode in the second bezel area through the second connection portion.

15. The display panel of claim 8, wherein the backbone conductive line and the plurality of branch conductive lines are strip-shaped, the backbone conductive line is disposed in the first bezel area, the plurality of branch conductive lines extend from the first bezel area in the second direction toward the display area, and the plurality of branch conductive lines are uniformly distributed in the display area.

16. The display panel of claim 2, wherein the first bezel area is a lower bezel area, the second bezel area is an upper bezel area, the bezel area further comprises a left bezel area and a right bezel area, and the left connection portion and the right connection portion are strip-shaped, wherein the left connection portion is connected to the cathode in the left bezel area and extends along an edge of the cathode located in the left bezel area, and the right connection portion is connected to the cathode in the right bezel area and extends along an edge of the cathode located in the right bezel area.

17. The display panel of claim 4, wherein the display panel further comprises a substrate and a pixel circuit disposed on the substrate, wherein the pixel circuit comprises a plurality of metal layers, and the first conductive line and the second conductive line are disposed in a same layer as at least one of the plurality of metal layers.

18. The display panel of claim 1, wherein the display panel comprises a substrate and an anode layer and a light-emitting layer that are disposed on the substrate, the light-emitting layer is disposed between the anode layer and the cathode, and the power supply connection portion is disposed in a same layer as the anode layer.

19. A display device, comprising the display panel of any one of claims 1 to 18, wherein the display device further comprises a flexible connection piece bonded to the bonding connection portion, at least one flexible connection piece is provided, and each of the at least one flexible connection piece is bonded to a corresponding bonding connection portion.

20. The display device of claim 19, wherein lines disposed on a flexible connection piece of the at least one flexible connection piece and connected to corresponding bonding connection portions are shorted.

01

11

02

12

**FIG. 1**

**FIG. 2**

**FIG. 3**

**FIG. 4**

**FIG. 5**

**FIG. 6**

**FIG. 7**

**FIG. 8**

**FIG. 9**

## INTERNATIONAL SEARCH REPORT

| International application No. |
| --- |
| **PCT/CN2023/070097** |

**A.    CLASSIFICATION OF SUBJECT MATTER**

H10K59/10(2023.01)i;  H01L27/15(2006.01)i

According to International Patent Classification (IPC) or to both national classification and IPC

**B.    FIELDS SEARCHED**

Minimum documentation searched (classification system followed by classification symbols)

H10K, H01L

Documentation searched other than minimum documentation to the extent that such documents are included in the fields searched

Electronic data base consulted during the international search (name of data base and, where practicable, search terms used)

CNTXT; ENTXTC; WPABSC; DWPI; VEN; ENTXT; IEEE; CNKI: 显示, 面板, 边框, 阴极, 电极, 电源, 绑定, 电压, 压降, 电压降, display, panel, frame, cathode, electrode, power, supply, bind, voltage, drop, IR

**C.    DOCUMENTS CONSIDERED TO BE RELEVANT**

| Category* | Citation of document, with indication, where appropriate, of the relevant passages | Relevant to claim No. |
| --- | --- | --- |
| PX | CN 114823837 A (YUNGU (GU'AN) TECHNOLOGY CO., LTD.) 29 July 2022 (2022-07-29) <br> entire document | 1-20 |
| X | CN 110047895 A (SHANGHAI TIANMA MICROELECTRONICS CO., LTD.) 23 July 2019 (2019-07-23) <br> description, paragraphs [0039]-[0059], and figures 1-7 | 1-20 |
| X | CN 110634916 A (KUNSHAN GOVISIONOX OPTOELECTRONICS CO., LTD.) 31 December 2019 (2019-12-31) <br> description, paragraphs [0026]-[0053], and figures 2-6 | 1-20 |
| X | CN 114255671 A (CHONGQING HKC OPTOELECTRONICS TECHNOLOGY CO., LTD. et al.) 29 March 2022 (2022-03-29) <br> description, paragraphs [0061]-[0094], and figures 1-11 | 1-20 |
| A | CN 111640774 A (BOE TECHNOLOGY GROUP CO., LTD. et al.) 08 September 2020 (2020-09-08) <br> entire document | 1-20 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **23 May 2023** | **24 May 2023** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/070097**

C.    DOCUMENTS CONSIDERED TO BE RELEVANT

| Category* | Citation of document, with indication, where appropriate, of the relevant passages | Relevant to claim No. |
|---|---|---|
| A | CN 113140589 A (BOE TECHNOLOGY GROUP CO., LTD.) 20 July 2021 (2021-07-20) entire document | 1-20 |
| A | JP 2010145661 A (CANON K. K.) 01 July 2010 (2010-07-01) entire document | 1-20 |
| A | JP 2015072761 A (JAPAN DISPLAY INC.) 16 April 2015 (2015-04-16) entire document | 1-20 |

Form PCT/ISA/210 (second sheet) (July 2022)

**EP 4 307 861 A1**

**INTERNATIONAL SEARCH REPORT**
**Information on patent family members**

| | International application No. |
|---|---|
| | **PCT/CN2023/070097** |

| Patent document cited in search report | | | Publication date (day/month/year) | Patent family member(s) | | | Publication date (day/month/year) |
|---|---|---|---|---|---|---|---|
| CN | 114823837 | A | 29 July 2022 | None | | | |
| CN | 110047895 | A | 23 July 2019 | CN | 110047895 | B | 08 June 2021 |
| CN | 110634916 | A | 31 December 2019 | None | | | |
| CN | 114255671 | A | 29 March 2022 | None | | | |
| CN | 111640774 | A | 08 September 2020 | WO | 2021249277 | A1 | 16 December 2021 |
| | | | | US | 2022336571 | A1 | 20 October 2022 |
| CN | 113140589 | A | 20 July 2021 | CN | 113140589 | B | 09 December 2022 |
| | | | | WO | 2021143846 | A1 | 22 July 2021 |
| JP | 2010145661 | A | 01 July 2010 | None | | | |
| JP | 2015072761 | A | 16 April 2015 | None | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210518090